# EUROPEAN PATENT APPLICATION

(11) **EP 3 901 645 A1**
(43) Date of publication of application: **27.10.2021**
(21) Application number: 20170354.3
(22) Date of filing: 20.04.2020
(51) Int. Cl.: G01R 31/42, G01R 31/64, H01G 2/18, H01G 4/224, H02H 7/16

(54) **A METHOD AND AN ARRANGEMENT FOR MONITORING AT LEAST ONE CAPACITOR IN AN ELECTRIC POWER CIRCUIT**

(71) Applicant: ABB Schweiz AG, 5400 Baden (CH)
(72) Inventor: Salmia, Teemu, 00380 Helsinki (FI); Vilkki, Markus, 00380 Helsinki (FI); Rapinoja, Hanna, 00380 Helsinki (FI)
(74) Representative: Kolster Oy Ab

(57) **Abstract**

The method comprises disconneting a failed capacitor (100) from the electric power circuit (10), measuring the current of each capacitor in the electric power circuit, and determining a failure of a capacitor in the electric power circuit based on the current measurement.

## Description

### FIELD

The invention relates to a method and an arrangement for monitoring at least one capacitor in an electric power circuit.

### BACKGROUND

Capacitors are widely used in the field of power electronics and electronics. A film capacitor is a commonly used capacitor type. A film capacitor may be a DC capacitor or an AC capacitor. A DC capacitor may be used e.g. as a capacitor in an intermediate voltage circuit in a converter. An AC capacitor may be used e.g. as an LCL filter capacitor in a network inverter in order to filter distortions passing to the network.

A film capacitor is based on the use of a plastic film as the dielectric medium in the capacitor. The plastic film may be coated with a metal forming an electrode or a separate metallic film may form an electrode in the capacitor. The most common plastic film used in high-power applications is polypropylene because it has a great voltage durability. The melting point of polypropylene is 160 degrees Celsius and it starts to disintegrate when the temperature reaches a level over 300 degrees Celsius. When disintegrating, propylene produces carbon hydrates and at the same time an increase in the pressure within the film capacitor. The film capacitor may disintegrate due to a too high voltage and/or due to a too high temperature and/or if the self-healing fails. Successful self-healings will also gradually increase the pressure within the capacitor.

A film capacitor may be provided with a protection mechanism which disconnects the film capacitor electrically from the circuit in which the film capacitor operates. A film capacitor may on the other hand be provided with a pressure sensor measuring the pressure within the capacitor. An overpressure measured by the pressure sensor may change the state of a switch indicating failure of the capacitor. The broken film capacitor remains connected into the power electric circuit in the second alternative.

A film capacitor may comprise a can. The can may comprise a body closed at one end with a bottom and at an opposite end with a cover. The body may be cylindrical. The dielectric film with the electrodes may be arranged within the can. The protection mechanism in the first alternative may be triggered by the increased pressure within the can when the capacitor fails. An increase of the pressure within the can over a certain threshold level, will cause the can to expand. The can may be provided with a weakening extending over the circumference of the body of the can near the cover of the can. The weakening will break due to the expansion of the capacitor can, whereby the cover will bounce upwards from the can and the internal wiring of the capacitor within the can will break.

The broken film capacitor will thus remain in a disconnected state in the power electric circuit for an indefinite time. It is often not possible from the outside to see that a capacitor is broken in the power electric circuit. The failure of the capacitor will probably not be noticed at all. This is especially the case if there are several capacitors working in parallel, whereby only a part of the total capacitance of the circuit has dropped off.

The control circuit of the network inverter may work even in a case in which all LCL capacitors have dropped off. The result of this is that the distortion fed into the network is on a much higher level compared to the planned distortion level.

The regulation of the circuit will be more difficult, the distortions will increase, and the warming up of the components will increase due to the reduction of the capacitance.

The reduction of the capacitance will change the resonance frequency or frequencies, whereby unwanted resonance phenomena occur. This applies to AC and DC film capacitors.

The reduction of the capacitance in the intermediate circuit results in a faster voltage increase and makes the control more difficult. This can be seen e.g. in an inaccuracy of the torque control signal provided to the electric motor.

The reduction of the capacitance in the LCL capacitor results in that a greater distortion is provided into the electrical network. This may cause disturbance to or overheating of other equipment connected to the electric network or the LCL may overheat. This will also make the control of the network inverter more difficult.

### SUMMARY

The invention relates to a novel method and arrangement for monitoring at least one capacitor in an electric power circuit.

The method according to the invention is defined in claim 1.

The method for monitoring at least one capacitor in an electric power circuit comprises
disconneting a failed capacitor from the electric power circuit,
measuring the current of each capacitor in the electric power circuit,
determining a failure of a capacitor in the electric power circuit based on the current measurement,
indicating a capacitor failure based on the current measurement.

The method according to the invention will improve the reliability of the electric apparatus.

The arrangement according to the invention is defined in claim 13.

### DRAWINGS

The invention will be described with reference to the accompanying drawings in which
Figure 1 shows an electric power converter,
Figure 2 shows a capacitor,
Figures 3 and 4 show a monitoring circuit for capacitors.

### DETAILED DESCRIPTION

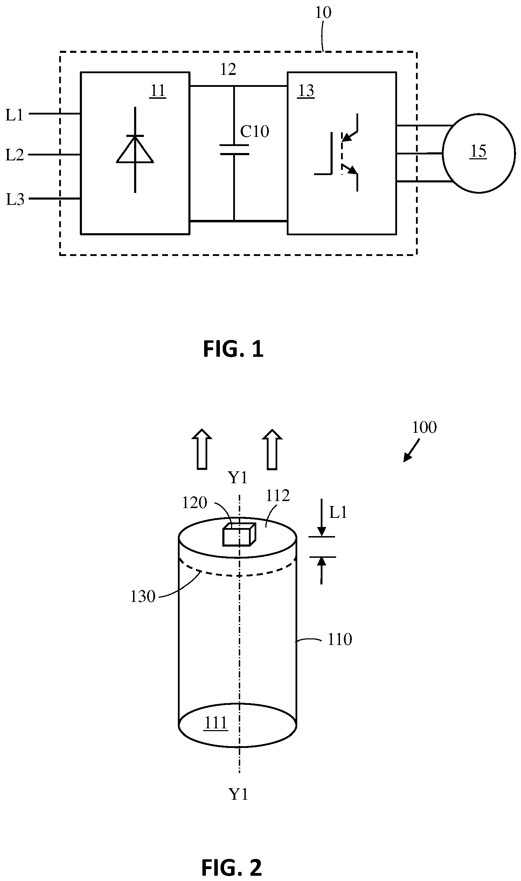

Figure 1 shows an electric power converter.

An electric power converter 10 may comprise a rectifier 11 transforming a three phase AC current into a DC current, an intermediate circuit 12 for smoothing the DC current and an inverter 13 for converting the DC current into a three phase AC current. The rectifier 11 may be based on a diode bridge, the intermediate circuit 12 may be based on capacitors C10, and the inverter 13 may be based on IGBT-switches (Insulated-Gate Bipolar Transistor). The electric power converter 10 may supply electric power to an electric motor 15.

A three phase L1, L2, L3 electric power may be supplied to the inputs of the rectifier 11. The DC output of the rectifier 11 is smoothed with the capacitors C1 in the intermediate voltage circuit 12. The DC voltage of the intermediate circuit 12 is then converted into a three phase AC voltage in the inverter 13 and the three phase AC voltage is supplied to the electric motor 15.

The capacitor C10 may be a DC film capacitor.

Figure 2 shows a capacitor.

The capacitor 100 is a can capacitor. The can capacitor 100 may be formed in a can having a body 110 with a bottom 111 and a cover 112. The bottom 111 and the cover 112 are attached to the axial ends of the body 110 so that a closed space is formed inside the body 110. The capacitor 100 may have an axial center line Y1-Y1. The capacitor plates may be formed within the can. The cover 112 of the body 110 may be provided with a connection piece 120. The capacitor plates may be connected via wires passing through the cover 112 of the can to the connection piece 120. The capacitor 100 may further be connected to the external circuit via the connection piece 120. The body 110 of the can may be provided with a weakening 130. The weakening 130 may be positioned at an axial distance L1 below the cover 112 of the can. The axial distance L1 may be rather short.

When the pressure within the capacitor 100 has increased to a certain threshold level, the can of the film capacitor 100 will start to expand. The weakening 130 in the body 110 of the can will break due to the expansion of the can of the capacitor. This will result in that the cover 112 bounces upwards from the body 110 of the can. The connection piece 120 will also bounce upwards with the cover 112. This means that the internal wiring leading from the capacitor plates within the body 110 of the can to the connection piece 120 will also break.

The weakening 130 forms a protection mechanism for the film capacitor 100. The protection mechanism 130 disconnects the film capacitor 100 electrically from the electrical power circuit in which the film capacitor 100 operates. The film capacitor 100 could be left permanently in the open circuit after the protection mechanism has tripped.

The faulty capacitor 100 is thus disconnected from the electrical power circuit in which the capacitor 100 worked.

The body 110 of the can may be cylindrical as shown in the figure. A horizontal cross section of the can 110 would thus be circular when the body 110 of the can is cylindrical. The cylindrical form of the body 110 of the can is a frequently used form in film capacitors 100. A horizontal cross-section of the body 110 of the can could, however, instead of circular be e.g. elliptic, rectangular, or polygonal.

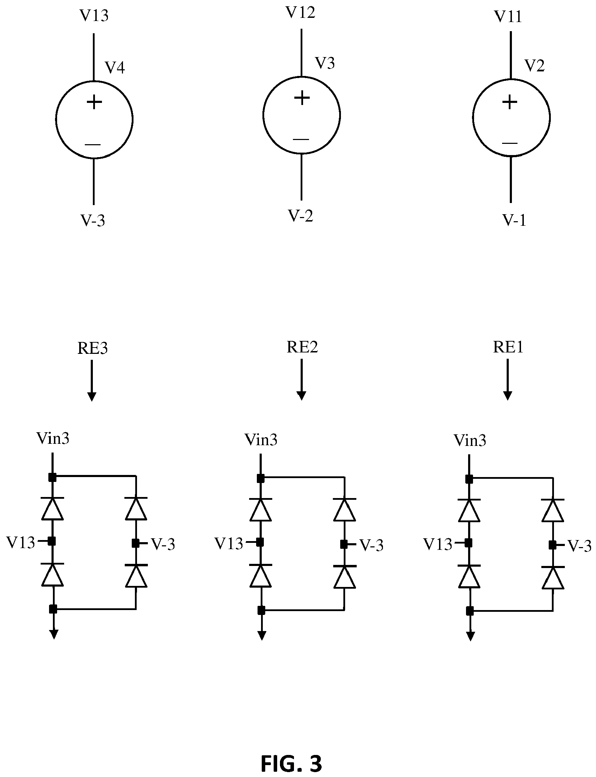

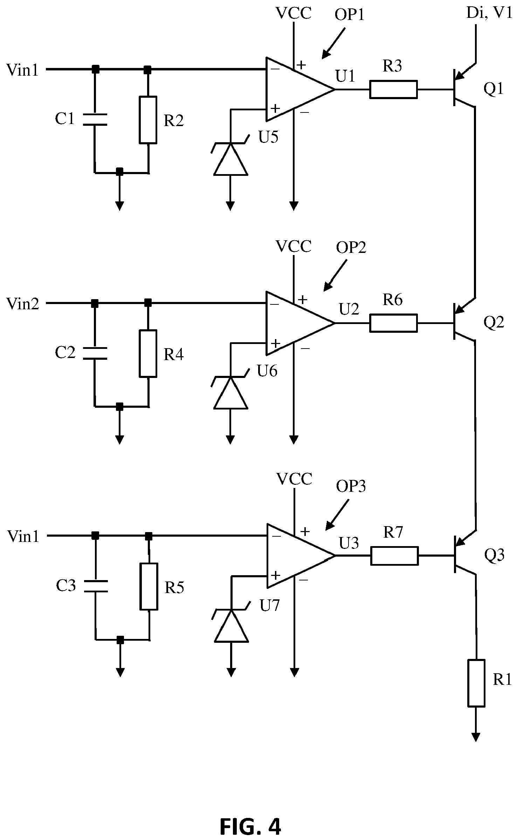

Figures 3 and 4 show a monitoring circuit for capacitors.

The monitoring circuit is intended for monitoring at least one AC capacitor.

Figure 3 shows voltages of current measurements and rectifier bridges, figure 4 shows measurement circuits.

One possibility to indicate the tripping of the protection mechanism of the capacitor is to measure the current of the capacitor. This current may be measured e.g. with a current transformer for each capacitor arranged on a printed circuit. A current transformer may comprise a transformer core surrounding the primary conductor i.e. the conductor leading to the capacitor. The transformer core may be provided with a secondary winding. The ends of the secondary winding may be connected to a current measurement resistance. The AC primary current flowing in a primary conductor produces via induction an AC secondary current in the secondary winding in the current transformer. The secondary current is proportional to the primary current. The secondary current flowing through the current measurement resistance produces an AC voltage over the current measurement resistance. The voltage over the current measurement resistance is thus proportional to the primary current. The voltage over the current measurement resistance may be compared to a reference voltage. A fault in the capacitor may be indicated when the voltage acting over the current measurement resistance exceeds the reference voltage. The other possibility is to operate the circuit in a reversed way. A fault in the capacitor is indicated only if no current flows through the current transformer i.e. there is no voltage over the current measurement resistance when operating the circuit in a reversed way.

The upper part of figure 3 shows AC voltage sources V2, V3, V4 representing the voltages acting over the current measurement resistances in the current transformers of the capacitors. The figures show a situation in a three phase AC power circuit with a capacitor in each phase.

The lower part of figure 3 shows rectifier bridges RE1, RE2, RE3 rectifying the three AC voltages V2, V3, V4 into DC voltages Vin1, Vin2, Vin3.

Figure 4 shows operational amplifiers OP1, OP2, OP3 working as comparators. A DC voltage source (not shown in the figures) may provide DC voltage VCC to the comparators OP1, OP2, OP3.

Each of the DC voltages Vin1, Vin2, Vin3 from the output of the rectifiers RE1, RE2, RE3 are connected over an RC circuit C1, R2; C2, R4; C3, R5 to the inverting input in a respective operational amplifier OP1, OP2, OP3. A reference voltage U5, U6, U7 is connected to the non-inverting input of the operational amplifier OP1, OP2, OP3. The reference voltage U5, U6, U7 may be produced over a diode connected to the non-inverting input of the operational amplifier OP1, OP2, OP3. The output of each operational amplifier OP1, OP2, OP3 is connected via a resistance R3, R6, R7 to the base of a respective transistor Q1, Q2, Q3.

Each operational amplifier OP1, OP2, OP3 compares the DC voltage Vin1, Vin2, Vin3 to the reference voltage U5, U6, U7.

When the DC input voltage Vin1, Vin2, Vin3 is greater than the reference voltage U5, U6, U7, the output U1, U2, U3 of the operational amplifier OP1, OP2, OP3 saturates towards the positive supply voltage VCC.

When the DC input voltage Vin1, Vin2, Vin3 is smaller than the reference voltage U5, U6, U7, the output U1, U2, U3 of the operational amplifier OP1, OP2, OP3 saturates towards the negative supply voltage O V.

When one of the DC input voltages Vin1, Vin2, Vin3 is smaller than the reference voltage U5, U6, U7, the output signal U1, U2, U3 of said operational amplifier OP1, OP2, OP3 will saturate towards the negative supply voltage 0 V. The base of the corresponding transistors Q1, Q2, Q3 will thus be in a zero-voltage state. This means that said transistor Q1, Q2, Q3 will be in a blocking state i.e. current cannot flow through the emitter and the collector of said transistor Q1, Q2, Q3.

The transistors Q1, Q2, Q3 are connected in series i.e. the emitter of the first transistor Q1 is connected to the collector of the second transistor Q2 and the emitter of the second transistor Q2 is connected to the collector of the third transistor Q3. The series connection of the transistors Q1, Q2, Q3 is connected via a resistor R1 to ground. The emitter of the third transistor Q3 is connected to one end of the resistor R1 and the other end of the resistor R1 is connected to ground. When all the transistors Q1, Q2, Q3 are in a conducting state, a current will flow through the resistor R1. A voltage V1 will thus act between point Di (the collector of the first transistor Q1) and the ground. Each of the transistors Q1, Q2, Q3, Q4 works as a switch. There is thus a series connection of switches from point Di to ground. When one of the transistors Q1, Q2, Q3 is in the blocked state, then the circuit from point Di to ground will be open. The voltage V1 from point Di to ground will thus be zero when at least one of the series connected switches is open i.e. the transistor Q1, Q2, Q3 is in a blocking state.

The point Di may thus be connected e.g. to the digital input of the power module of the electric circuit 10. The digital input of the power module in the electric circuit 10 will thus be in a low state, when at least one of the transistors Q1, Q2, Q3 is in the blocked state. The fact that the input of the digital input of the power module of the electric circuit 10 is in the low state may thus be interpreted to mean that at least one of the capacitors 100 fails.

The reference voltages U5, U6, U7 in the operational amplifiers OP1, OP2, OP3 may be chosen so that the current flowing through the capacitors 100 is enough to produce a voltage higher than the reference voltage when the LCL filter is connected to the AC network. This makes it possible to start the system normally.

Another possibility to indicate the tripping of the protection mechanism of the capacitor 100 is to add a pressure measuring device into the film capacitor 100. The pressure of the pressure measuring device could then be measured in order to be able to decide when an over pressure situation occurs.

The circuit for monitoring at least one capacitor shown in figures 3-5 is intended for use in connection with a three-phase electric power circuit comprising three capacitors 100. The circuit comprises thus three parallel branches i.e. one branch for each capacitor 100. The circuit could comprise one branch, two branches, three branches etc. depending on the amount of capacitors to be monitored.

The circuit could naturally be modified so that the transistors Q1, Q2, Q3 would not be connected in series. The emitters of each transistor Q1, Q2, Q3 would then be connected via a resistance to ground. Each transistor Q1, Q2, Q3 would then indicate separately the condition of the respective capacitor.

An arrangement for monitoring at least one capacitor (100) in an electric power circuit (10) may comprise
disconnecting means in each capacitor (100) for disconneting a failed capacitor (100) electrically from the electric power circuit (10),
a current transformer for measuring the current of each capacitor (100) in the electric power circuit (10),
an electric circuit based on a comparator (OP1, OP2, OP3) for determining a failure of a capacitor (100) in the electric power circuit (10) based on the current measurement, the comparator (OP1, OP2, OP3) comparing the voltage (V11, V12, V13) acting over a current measurement resistance in the current transformer with a predetermined voltage (U5, U6, U7) in order to determine whether current flows to the capacitor (100) or not and thereby whether the capacitor (100) has failed or not,
a transistor (Q1, Q2, Q3) connected to an output of the comparator (OP1, OP2, OP3), said transistor (Q1, Q2, Q3) functioning as a switch indicating a capacitor (100) failure based on the result of the comparison in the comparator (OP1, OP2, OP3).

The invention may be used to monitor at least one capacitor in an electric power circuit.

The figures 3 and 4 show a monitoring circuit for at least one AC capacitor. A monitoring circuit for at least one DC capacitor may be realized in a corresponding way. Rectifiers RE1, RE2, RE3 are naturally not needed in connection with DC capacitors.

The invention is naturally no restricted to be used only in connection with an electric power converter shown in figure 1. The invention may be used in connection with any electrical power circuit comprising capacitors. The electrical power circuit may e.g. comprise LCL-filters or LC-filters.

The invention and its embodiments are not limited to the examples shown in the figures, but the invention may vary within the scope of the protection defined by the claims.

## Claims

1. A method for monitoring at least one capacitor (100) in an electric power circuit (10), the method comprising
disconneting a failed capacitor (100) from the electric power circuit (10),
measuring the current of each capacitor (100) in the electric power circuit (10),
determining a failure of a capacitor (100) in the electric power circuit (10) based on the current measurement,
indicating a capacitor (100) failure based on the current measurement.

2. The method according to claim 1, wherein the current of each capacitor (100) is measured with a current transformer.

3. The method according to claim 1 or 2, wherein the capacitor (100) is a film capacitor.

4. The method according to claim 3, wherein the disconnection of the failed capacitor (100) from the electric power circuit (10) is based on an increase of the pressure within the capacitor (100) above a predetermined threshold level.

5. The method according to claim 3 or 4, wherein the film capacitor (100) comprises a can (110), the dielectric film and the electrodes in the capacitor (100) being provided within the can (110).

6. The method according to claim 5, wherein the film capacitor (100) comprises means for disconnecting the capacitor (100) electrically from the electric power circuit (10).

7. The method according to claim 6, wherein the means for disconnecting the capacitor (100) electrically from the electric power circuit (10) comprises a weakening (130) in an outer circumference of the can (110), said weakening (130) breaking when the pressure within the can (110) increases above a threshold level due to a capacitor (100) failure, whereby a cap (112) of the can (110) bounces upwards from the can (110) resulting in that an electrical connection between a terminal (120) positioned on the cap (112) of the can (110) and the capacitor (100) within the can (110) brakes.

8. The method according to any one of claims 1 to 7, wherein failure of a capacitor (100) is determined when a voltage (V2, V3, V4) measured over the current measurement resistance in the current transformer associated with the capacitor (100) exceeds a predetermined threshold value (U5, U6, U7).

9. The method according to any one of claims 1 to 7, wherein failure of a capacitor (100) is determined when a voltage (V2, V3, V4) measured over the current measurement resistance in the current transformer associated with the capacitor (100) is zero.

10. The method according to any one of claims 1 to 9, comprising
measuring an AC voltage (V2, V3, V4) acting over a current measurement resistance in each current transformer,
rectifying the measured AC voltage (V2, V3, V4) in a rectifier (RE1, RE2, RE3) into a DC voltage (Vin1, Vin2, Vin3),
comparing the DC voltage (Vin1, Vin2, Vin3) in an operational amplifier (OP1, OP2, OP3) with a predetermined threshold voltage (U5, U6, U7),
connecting an output of the operational amplifier (OP1, OP2, OP3) to a base of a transistor (Q1, Q2, Q3),
connecting the emitter of each transistor (Q1, Q2, Q3) over a resistance to the ground,
measuring a voltage (V1) between the collector and the ground of each transistor (Q1, Q2, Q3),
indicating capacitor (100) failure when the voltage (V1) between the collector and the ground is zero.

11. The method according to claim 10, comprising
connecting the transistors (Q1, Q2, Q3) in series with each other and over a resistance (R1) to ground,
measuring a voltage (V1) between the collector of the first transistor (Q1) and the ground,
indicating capacitor (100) failure when the voltage (V1) between the collector of the first transistor (Q1) and the ground is zero.

12. The method according to any one of claims 1 to 11, wherein the electric apparatus (300) is an electric drive comprising a power converter (300) for driving an electric motor (350).

13. An arrangement for monitoring at least one capacitor (100) in an electric power circuit (10), the arrangement comprising
disconnecting means in each capacitor (100) for disconneting a failed capacitor (100) electrically from the electric power circuit (10),
a current transformer for measuring the current of each capacitor (100) in the electric power circuit (10),
an electric circuit based on a comparator (OP1, OP2, OP3) for determining a failure of a capacitor (100) in the electric power circuit (10) based on the current measurement, the comparator (OP1, OP2, OP3) comparing the voltage (V11, V12, V13) acting over a current measurement resistance in the current transformer with a predetermined voltage (U5, U6, U7) in order to determine whether current flows to the capacitor (100) or not and thereby whether the capacitor (100) has failed or not,
a transistor (Q1, Q2, Q3) connected to an output of the comparator (OP1, OP2, OP3), said transistor (Q1, Q2, Q3) functioning as a switch indicating a capacitor (100) failure based on the result of the comparison in the comparator (OP1, OP2, OP3).
